Europäisches Patentamt

(19) European Patent Office

Office européen des brevets

(11) Numéro de publication : **0 328 465 B1**

# (12) FASCICULE DE BREVET EUROPEEN

(45) Date de publication du fascicule du brevet :
**13.11.91 Bulletin 91/46**

(51) Int. Cl.⁵ : **H03K 17/04**

(21) Numéro de dépôt : **89420028.6**

(22) Date de dépôt : **01.02.89**

(54) **Circuit de commande de grille d'un transistor MOS de puissance fonctionnant en commutation.**

Le dossier contient des informations techniques présentées postérieurement au dépôt de la demande et ne figurant pas dans le présent fascicule.

(30) Priorité : **04.02.88 FR 8801550**

(43) Date de publication de la demande :
**16.08.89 Bulletin 89/33**

(45) Mention de la délivrance du brevet :
**13.11.91 Bulletin 91/46**

(84) Etats contractants désignés :
**DE FR GB IT NL**

(56) Documents cités :
**DE-A- 1 762 420
DE-A- 3 405 936
US-A- 3 740 581
PATENT ABSTRACTS OF JAPAN, vol. 10, no. 58 (E-386)[2115], 7 mars 1986; & JP-A-60 210 028**

(73) Titulaire : **SGS-THOMSON MICROELECTRONICS S.A.
7, Avenue Galliéni
F-94250 Gentilly (FR)**

(72) Inventeur : **Pavlin, Antoine
Résidence Zola Bt C1 Chemin Gilles Borel
F-13100 Aix en Provence (FR)**

(74) Mandataire : **de Beaumont, Michel
1bis, rue Champollion
F-38000 Grenoble (FR)**

## Description

La présente invention concerne des circuits de commande de grille de transistors MOS de puissance fonctionnant en commutation et s'applique plus particulièrement à des transistors dits VDMOS (MOS vertical de type diffusé) réalisés sur un substrat en même temps que des transistors bipolaires verticaux.

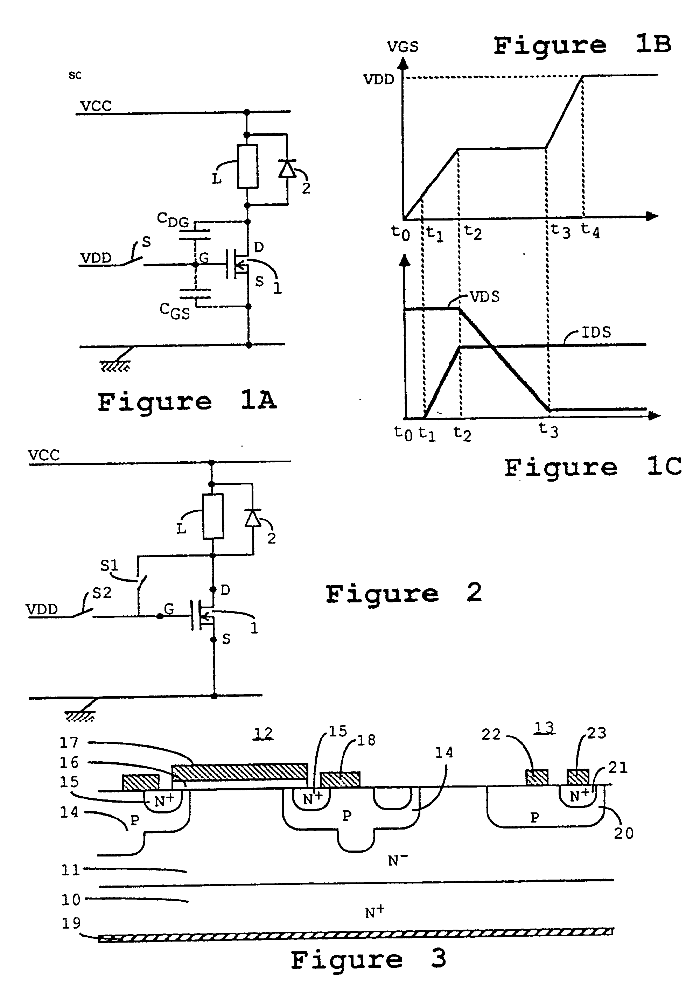

La présente invention se base sur une analyse du fonctionnement à la fermeture d'un transistor MOS de puissance. Cette analyse va être exposée en relation avec un schéma simplifié de connexion d'un transistor MOS de puissance en figure 1A et des courbes de fonctionnement indiquant l'évolution de la tension de grille à la fermeture (figure 1B) et l'évolution de la tension drain/source, $V_{DS}$, et du courant drain/source, $I_{DS}$, à la fermeture (figure 1C).

La figure 1A représente un transistor MOS de puissance 1 destiné à commander le passage du courant dans une charge L, une tension d'alimentation $V_{CC}$ (par exemple 200 volts) étant appliquée à une borne de la charge L et l'autre borne de cette charge étant reliée au drain D du transistor MOS de puissance 1 dont la source est reliée à la masse. La charge L est couramment une charge inductive et on a représenté en parallèle sur cette charge une diode roue libre 2. On a également représenté en pointillés, entre le drain et la grille du transistor MOS la capacité drain/grille $C_{DG}$ et entre la grille et la source du transistor MOS la capacité grille/source $C_{GS}$. Un interrupteur S permet l'application d'une tension $V_{DD}$ sur la grille du transistor MOS, ici un transistor enrichi à canal N, pour provoquer sa fermeture.

Si l'on considère les courbes des figures 1B et 1C, lors de la fermeture du commutateur S, à l'instant t0, la tension sur la grille commence à croître jusqu'à l'instant t1 où l'on atteint la tension de seuil de commande de la grille du transistor MOS. A cet instant, le courant drain/source commence à croître jusqu'à un instant t2 où le courant drain/source atteint la valeur du courant dans la diode roue libre. Jusqu'à cet instant t2, la tension $V_{DS}$ reste élevée. Entre les instants t2 et t3, la capacité $C_{DG}$ se décharge et la tension drain, source tend vers une valeur très faible liée à la résistance à l'état passant du transistor de type DMOS. Après l'instant t3, la tension de grille s'élève jusqu'au niveau complet de la source de tension de grille $V_{DD}$ pour maintenir le transistor DMOS à l'état conducteur avec une résistance à l'état passant minime. Ainsi, la source de tension de grille fournit de l'énergie essentiellement entre les instants t1, t2 et t2, t3 correspondant à la charge de la capacité $C_{GS}$ et à la décharge de la capacité $C_{DG}$. A titre d'exemple, pour un transistor DMOS de type vertical alimenté sous 200 volts ayant une résistance à l'état passant de 0,18 volt, la charge de grille totale requise est typiquement de 40 nanocoulombs. Si la commutation est effectuée en 100 ns, le courant crête à fournir à la grille du transistor DMOS est de 400 milliampères. Dans certaines applications, cette dissipation de courant peut être considérée comme excessive.

Ainsi, la présente invention se base sur cette analyse et sur la constatation du fait que la tension $V_{DS}$ sur le drain du transistor MOS reste nettement supérieure à $V_{DD}$ pratiquement jusqu'à l'instant t3, comme le montre la figure 1C.

Ainsi, la présente invention propose, pendant la phase de fermeture de prélever le courant de charge de grille du transistor DMOS sur son drain tant que la tension de drain est supérieure à la tension de grille, pour éviter la consommation de l'alimentation de grille. Un avantage supplémentaire de l'invention est d'accélérer la commutation, du fait que la tension de drain étant nettement supérieure à la tension d'alimentation de grille, $V_{DD}$, les capacités grille/source et grille/drain seront plus vite chargée et déchargée, respectivement.

Ainsi, la présente invention prévoit un circuit de commande de grille d'un transistor MOS de puissance dont une première électrode principale est connectée à une tension haute par l'intermédiaire d'une charge, dont une deuxième électrode principale est connectée à la masse et dont la grille est connectée, pendant la durée de fermeture, à une source de tension basse, comprenant des moyens pour relier au moment de la fermeture du transistor MOS de puissance sa première électrode principale à sa grille.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A, 1B et 1C ont été décrites précédemment pour illustrer l'état de la technique et le problème que la présente invention vise à résoudre ;

la figure 2 représente très schématiquement un circuit selon la présente invention ;

la figure 3 représente une structure associant des transistors VDMOS et des transistors bipolaires verticaux ;

la figure 4 représente un mode de réalisation d'un circuit de commande de grille selon la présente invention ;

la figure 5 représente un exemple de circuit inverseur à bootstrap ;

la figure 6 représente un exemple de circuit antisaturation adapté à la mise en oeuvre de la présente invention.

La figure 2 représente très schématiquement un circuit selon la présente invention. On retrouve dans cette figure le transistor MOS 1, la charge L, et la diode roue libre 2 déjà illustrés en figure 1. En outre, le circuit selon la présente invention comprend un premier commutateur S1 entre le drain et la grille du transistor MOS 1 et un deuxième commutateur S2 entre la tension $V_{DD}$ et la grille du transistor 1, ce commutateur S2 correspondant au commutateur S de la figure 1A.

Selon la présente invention, il est proposé, lorsqu'on veut fermer le transistor MOS 1, de fermer simultanément les interrupteurs S1 et S2. Ainsi, le courant de charge de grille est prélevé à travers la charge sur le drain du transistor. Dès que la tension de drain se rapproche de la tension $V_G$, le commutateur S1 est ouvert, le commutateur S2 étant maintenu fermé pour maintenir une tension optimale de conduction sur la grille du transistor MOS. Ainsi, la quantité de courant extraite de la source de tension d'alimentation de grille $V_{DD}$ est considérablement réduite, l'énergie étant principalement prélevée sur la tension d'alimentation principale $V_{CC}$. D'autre par, la durée de fermeture est plus courte, les condensateurs étant chargés sous une tension plus élevée.

Un mode de réalisation particulier de la présente invention va être décrite plus en détail dans le cas où le transistor MOS 1 est un transistor MOS de puissance vertical de type diffusé (VDMOS) réalisé dans une technologie compatible avec la réalisation simultanée dans un même substrat de transistors bipolaires verticaux. Une vue en coupe d'une telle structure est illustrée très schématiquement à titre d'exemple en figure 3 dans laquelle on notera que les diverses épaisseurs de couches et dimensions latérales des diverses zones ne sont pas représentées à l'échelle mais ont simplement un but d'illustration.

Dans cette figure 3, on considère un substrat comprenant une couche inférieure ou face arrière 10 de type N⁺ et une couche supérieure 11 de type N⁻. Dans ce substrat sont formés, d'une part, au moins une transistor VDMOS 12 et, d'autre part, au moins un transistor bipolaire vertical 13.

Le transistor VDMOS comprend des zones diffusées de type P 14 dans lesquelles sont formées des régions de source de type N⁺ 15. Entre les limites de deux zones 14 sont formées sur la surface de substrat une couche d'isolement 16 et une couche conductrice de grille 17. Sur les régions de type N⁺ 15 sont formées des métallisations de source 18. La couche 10 correspond au drain du transistor MOS vertical et est revêtue d'une métallisation de face arrière 19. Ainsi, quand un potentiel est appliqué sur la grille 17 du transistor VDMOS, les parties en affleurement des régions de type P 14 subissent une inversion de type de polarité et une conduction s'établit entre les métallisations de source 18 et la métallisation de drain 19.

Le transistor bipolaire 13 comprend une région de base 20 de type P formée simultanément avec les régions 14 du transistor VDMOS et une région d'émetteur 21 de type N⁺ formée simultanément avec les régions de source 15. La région de base 20 est revêtue d'une métallisation de base 22 et la région d'émetteur 21 est revêtue d'une métallisation d'émetteur 23. Le collecteur de ce transistor bipolaire correspond également au substrat 10, 11 et à la métallisation 19.

Ainsi, cette technologie conduit à des transistors VDMOS et à des transistors bipolaires verticaux dont les électrodes de drain et de collecteur sont systématiquement interconnectées. Un avantage de cette technologie est, en outre, qu'il est possible de réaliser simultanément des transistors MOS latéraux pour réaliser des circuits logiques.

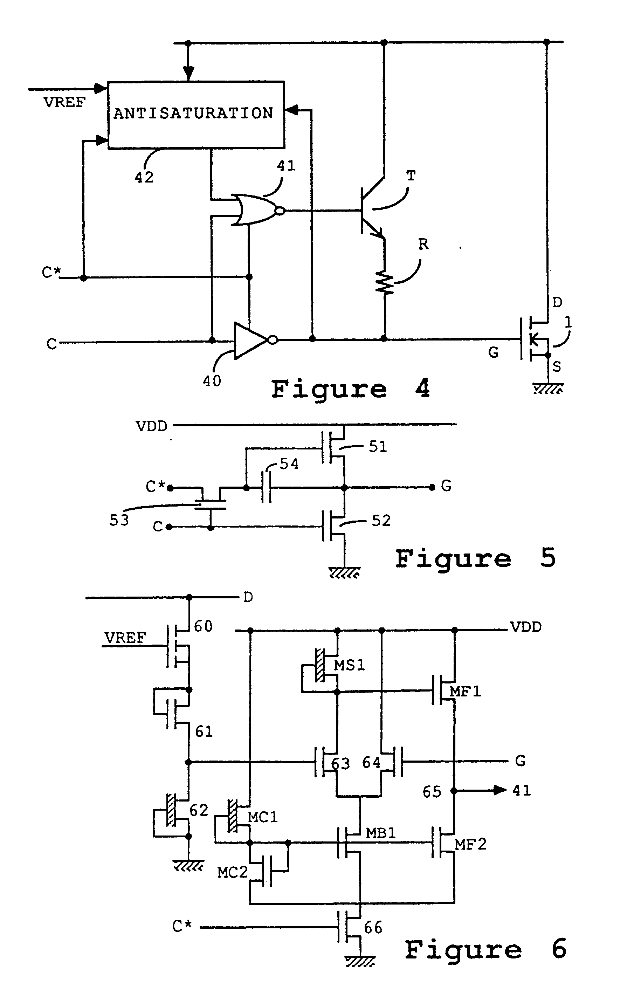

La figure 4 représente un exemple simplifié d'un circuit selon la présente invention associant un transistor VDMOS 1 que l'on souhaite commuter à un transistor bipolaire vertical T ayant la fonction du commutateur S1 de la figure 2. Le transistor T est relié entre le drain D et la grille G du transistor VDMOS 1, en série avec une résistance limitatrice R. Un signal de commande C est appliqué, d'une part, directement à la grille du VDMOS 1 par l'intermédiaire d'un inverseur 40, d'autre part, à une première entrée d'une porte NON OU 41 dont la deuxième entrée provient d'un circuit logique 42. Ce circuit logique 42 est conçu pour que la porte NON OU devienne passant en même temps que l'inverseur 40 dès que le signal de commande C passe à bas niveau. On réalise donc la fonction de charge de la grille par la mise en conduction du transistor bipolaire T dès l'application du signal C. D'autre part, le circuit logique 42 comprend des moyens pour comparer la tension de grille du transistor VDMOS à une tension de référence $V_{REF}$ de façon à invalider la porte NON OU 41 et donc à interrompre la conduction du transistor T dès que la tension sur la borne G du transistor VDMOS se rapproche de la tension $V_{DS}$ du transistor VDMOS 1.

Outre le signal de commande C, le signal inverse C* est également fourni dans le but de réduire la dissipation de courant dans l'état non conducteur. Ce signaux C et C* peuvent être classiquement fournis à partir d'un trigger de Schmitt. Pour obtenir cette réduction de consommation, l'inverseur 40 et la porte NON OU 41 sont des circuits de type à bootstrap (circuit amplificateur d'amorçage).

Les circuits de type bootstrap sont connus dans la technique. Un exemple d'inverseur à bootstrap est indiqué en figure 5. Ce circuit comprend entre la tension d'alimentation de grille $V_{DD}$ et la masse deux transistors MOS logiques en série 51 et 52. Le transistor 52 reçoit le signal de commande C et le transistor MOS 51 reçoit le signal de commande C* par l'intermédiaire d'un commutateur 53. Un condensateur de bootstrap 54 est relié entre la grille et la source du transistor MOS 51, d'où il résulte qu'au moment où le signal de commande C passe à l'état bas, la tension de grille du transistor 51 se trouve à une valeur égale à 2 $V_{DD}$. Comme cela est connu, de tels circuits permettent de fournir un courant de sortie maximal à l'instant de la commutation tout en dissipant une puissance minimale à l'état de coupure.

En reprenant le circuit de la figure 4, comme on l'a indiqué précédemment, quand le signal C passe à bas niveau, la sortie de la porte NON OU à bootstrap commute de bas à haut niveau et commence à alimenter en courant de base le transistor bipolaire T, par exemple avec un courant de l'ordre de 2 mA. Le gain en courant du transistor bipolaire fournit environ 400 mA à la grille du VDMOS à partir de la haute tension présente au niveau de la borne commune drain/collecteur par l'intermédiaire de la résistance d'émetteur R qui peut par exemple avoir une valeur de 18 ohms. En même temps, le signal $C^*$ est appliqué au circuit logique 42 pour forcer sa sortie vers la porte NON OU 41 à bas niveau. Quand le courant de drain du transistor VDMOS 1 atteint sa valeur maximale, la tension de grille atteint et maintient une valeur $V_{GS} = VT + I_{DS}/gm$ où VT est la tension de seuil de ce transistor VDMOS et gm sa transconductance, la valeur de $V_{GS}$ est classiquement de l'ordre de 4 volts. La tension de drain du VDMOS commence alors à chuter.

La figure 6 représente un exemple du circuit logique 42 permettant de détecter cette chute de la tension de drain. Ce circuit comprend un diviseur de tension comprenant en série entre la borne de drain D et la masse un transistor de type VDMOS 60 dont la grille reçoit la tension de référence, un transistor MOS à enrichissement 61 dont la grille est connectée à son drain, et un transistor MOS du type à appauvrissement 62 dont la grille est connectée à sa source. La tension au point de connexion drain/source des transistors 61 et 62 est fournie à un comparateur comprenant essentiellement des transistors MOS 63 et 64, la grille du transistor 63 recevant la tension sur le point de connexion des transistors 61 et 62 et la grille du transistor 64 recevant la tension sur la borne G (grille du transistor VDMOS de puissance 1). La sortie du circuit vers le deuxième entrée de la porte NON OU 41 est prélevée sur une borne 65. Les autres éléments de ce circuit sont classiques. On notera dans cette figure que les transistors MOS à appauvrissement sont représentés comme le transistor 62 avec des hachures entre les deux traits verticaux. On notera également que le signal $C^*$ appliqué sur un transistor MOS 66 permet d'inhiber le fonctionnement du comparateur et donc d'éviter toute consommation de puissance tant que le signal de commande C est à l'état haut. Ainsi, le comparateur 63, 64 compare la tension de grille du transistor VDMOS de puissance à une tension égale à $V_{DS} - \delta V - VT$ où $V_{DS}$ est la tension de drain du DMOS, $\delta V$ est la chute de tension aux bornes des transistors MOS logiques 61 et 62 et VT est la tension de seuil du transistor VDMOS 60. Ainsi, le circuit logique 42 commute dès que $V_{GS}$ devient supérieur à $V_{DS} - \delta V - VT$. A ce stade, la tension de drain du transistor VDMOS a commuté d'une haute tension initiale à environ 12 volts. La tension d'émetteur du transistor bipolaire est alors d'environ 10 volts. Ainsi, la porte NON OU 41 coupe le courant de base du transistor bipolaire alors que celui-ci est dans un état de quasisaturation avec une chute de tension collecteur/émetteur d'environ 2 volts. Le fait d'empêcher le transistor bipolaire d'atteindre un état de complète saturation assure une décharge rapide de celui-ci et sa coupure avant coupure du transistor VDMOS et élévation de la tension de drain/collecteur. Dans ces conditions, le transistor bipolaire peut être utilisé jusqu'à sa tension de claquage collecteur/émetteur qui est égale à la tension de claquage drain/source du transistor VDMOS du fait de la technologie utilisée illustrée en figure 3.

Bien entendu, les circuits décrits précédemment ne constituent qu'un mode de réalisation de l'invention et pourrait être soumis à de nombreuses variantes, notamment en ce qui concerne les détails des circuits à bootstrap et du circuit logique 42 qui pourrait être réalisé avec d'autres composants logiques avec les technologies de fabrication du transistor VDMOS.

## Revendications

1. Circuit de commande de grille d'un transistor MOS de puissance (1) dont une première électrode principale (D) est connectée à une tension haute ($V_{CC}$) par l'intermédiaire d'une charge inductive (L) en parallèle sur une diode roue libre (2), dont une deuxième électrode principale (S) est connectée à la masse et dont la grille (G) est connectée, pendant la durée de fermeture, à une source de tension basse ($V_{DD}$), caractérisé en ce qu'il comprend des moyens (S1) pour connecter au moment de la fermeture du transistor MOS de puissance sa première électrode principale à sa grille.

2. Circuit de commande de grille selon la revendication 1, dans lequel le transistor MOS de puissance (1) est du type VDMOS réalisé dans un substrat semiconducteur où est également formé un transistor bipolaire vertical (T), la face arrière du substrat correspondant au drain du VDMOS et au collecteur du transistor bipolaire, ledit train (D) constituant ladite première électrode principale, caractérisé en ce que l'émetteur du transistor bipolaire est relié à la grille du transistor VDMOS et en ce que sa base reçoit le signal de fermeture (C) en même temps que la grille du VDMOS.

3. Circuit de commande de grille selon la revendication 2, caractérisé en ce que ledit émetteur est relié à ladite grille par l'intermédiaire d'une résistance (R).

4. Circuit de commande de grille selon l'une quelconque des revendications 2 ou 3, caractérisé en ce qu'il comprend des moyens (42 ; 63, 64) pour bloquer la conduction du transistor bipolaire dès que la tension de drain du VDMOS se rapproche de sa tension de grille.

5. Circuit de commande de grille selon l'une quelconque des revendications 2 à 4, caractérisé en ce que les tensions de grille du VDMOS et de base du transistor bipolaire sont appliquées en réponse à un ordre de commande par l'intermédiaire de circuits (40, 41) de type bootstrap.

## Patentansprüche

1. Gate-Steuerschaltung für einen MOS-Leistungstransistor (1), dessen erste Hauptelektrode (D) über eine zu einer Freilaufdiode (2) parallel geschalteten Induktivität (L) an einer Hochspannung ($V_{CC}$) liegt, dessen zweite Hauptelektrode (S) geerdet ist, und dessen Gate (G) während der Durchschaltdauer mit einer Niederspannungsquelle ($V_{DD}$) verbunden ist, **gekennzeichnet** durch einen Schalter (S1) zum Verbinden der ersten Hauptelektrode mit dem Gate im Zeitpunkt des Durchschaltens des MOS-Leistungstransistors.

2. Gate-Steuerschaltung nach Anspruch 1, bei welcher der MOS-Leistungstransistor (1) ein VDMOS-Typ ist, der in einem Halbleitersubstrat realisiert ist, in dem auch ein vertikaler bipolarer Transistor (T) ausgebildet ist, wobei die Rückseite des Substrats dem VDMOS-Drain und dem Kollektor des bipolaren Transistors entspricht, und dieser Drain (D) die erste Hauptelektrode bildet, dadurch **gekennzeichnet**, daß der Emitter des bipolaren Transistors mit dem Gate des VDMOS-Transistors verbunden ist, und seine Basis das Durchschaltsignal (C) zur selben Zeit wie das VDMOS-Gate empfängt.

3. Gate-Steuerschaltung nach Anspruch 2, dadurch **gekennzeichnet**, daß der Emitter mit diesem Gate über einen Widerstand (R) verbunden ist.

4. Gate-Steuerschaltung nach Anspruch 2 oder 3, **gekennzeichnet** durch Vorrichtungen (42, 63, 64) zum Unterbrechen der Leitfähigkeit des bipolaren Transistors dann, wenn die Drain-Spannung des VDMOS sich seiner Gate-Spannung annähert.

5. Gate-Steuerschaltung nach einem der Ansprüche 2 bis 4, dadurch **gekennzeichnet**, daß die Spannungen des VDMOS-Gate und der Basis des bipolaren Transistors abhängig von einem Steuerbefehl über einen Bootstrap-Schaltkreis (Urlader) angelegt werden.

## Claims

1. A gate control circuit for a power MOS transistor (1), the first main electrode of which (D) is connected to a high current voltage ($V_{CC}$) through an inductive load (L) parallel connected with a free-wheel diode, the second main electrode of which (S) is grounded and the gate (G) of which is connected, during the switching ON period, to a low voltage source ($V_{DD}$), characterized in this that it comprises means (S1) for connecting at the switching ON of the power MOS transistor its first main electrode to its gate.

2. A gate control circuit according to claim 1, wherein the power MOS transistor (1) is of the VDMOS-type realized in a semiconductor substrate where a vertical bipolar transistor (T) is also formed, the rear face of the substrate corresponding to the VDMOS drain and to the bipolar transistor collector, said drain (D) constituting said first main electrode, characterized in this that the bipolar transistor emitter is connected to the VDMOS transistor gate and its base receives the switching ON signal (C) at the same time as the VDMOS gate.

3. A gate control circuit according to claim 2, characterized in this that said emitter is connected to said gate through a resistor (R).

4. A gate control circuit according to claim 2, characterized in this that it comprises means (42 ; 63, 64) for blocking the conduction of the bipolar transistor as soon as the drain voltage of the VDMOS is approaching its gate voltage.

5. A gate control circuit according to claim 2, wherein the voltages of the VDMOS gate and of the bipolar transistor base are supplied through bootstrap circuits (40, 41) in response to a control order.

Figure 1A

Figure 1B

Figure 1C

Figure 2

Figure 3

Figure 4

Figure 5

Figure 6